# EUROPÄISCHE PATENTSCHRIFT

(11) **EP 2 507 831 B1**
(45) Veröffentlichungstag und Bekanntmachung des Hinweises auf die Patenterteilung: **26.02.2020**
(21) Anmeldenummer: 10787730.0
(22) Anmeldetag: 29.11.2010
(51) Int. Cl.: H01L 25/075, F21K 9/23, H01L 33/50, F21Y 115/10, F21Y 113/13

(54) **RETROFIT LED-LAMPE MIT WARMWEISSEM, INSBESONDERE FLAMMENARTIGEM WEISSLICHT**
RETROFIT LED-LAMP WITH WARMWHITE, FLAME-LIKE LIGHT
VOYANT À LED D'ADAPTATION AVEC LUMIÈRE BLANCHE CHAUDE, NOTAMMENT DE TYPE FLAMME

(30) Priorität: 30.11.2009 DE 102009056114; 25.02.2010 DE 102010002332
(43) Veröffentlichungstag der Anmeldung: 10.10.2012
(73) Patentinhaber: Tridonic Jennersdorf GmbH, 8380 Jennersdorf (AT)
(72) Erfinder: PACHLER, Peter, A-8042 Graz (AT)
(74) Vertreter: Rupp, Christian
(86) Internationale Anmeldenummer: PCT/EP2010/068413
(87) Internationale Veröffentlichungsnummer: WO 2011/064363

(56) Entgegenhaltungen:
- CN-Y- 201 126 821
- DE-A1-102008 021 662
- US-A1- 2005 127 381
- US-A1- 2006 152 140
- US-B1- 6 234 648

## Beschreibung

Die vorliegende Erfindung bezieht sich ganz allgemein auf sogenannte Retrofit-LED-Lampen. Darunter wird in der Fachwelt eine LED-Lampe verstanden, die mit einem Sockel versehen ist, der sie als Ersatz-Leuchtmittel in bestehende genormte Fassungen für Halogen- oder Glühbirnenlampen verwendbar macht.

Die elektrische Versorgung einer solchen Lampe wird durch eine Niedervolt (z.B. 12V/24V) Wechselspannung und Gleichspannung oder durch 110V/220V Wechselspannung gewährleistet. Derartige Retrofit-LED-Lampen zeichnen sich dadurch aus, dass eine Konverter- oder Treiberschaltung für die eine oder mehreren LEDs in der LED-Lampe innerhalb des Gehäuses, vorzugsweise im Bereich des Sockels der LED-Lampe angeordnet ist. Da die Treiberschaltung und die LEDs Verlustleistung erzeugen und diese zu einer Erwärmung der Lampe führt, muss für eine ausreichende Wärmeabfuhr und entsprechend niedere Temperaturen der LED Lampe ausreichend großen Kühlkörper gesorgt werden. Diese Probleme hinsichtlich der Wärmeabfuhr spiegeln sich insbesondere darin wieder, dass bei dem vorhandenen begrenzten Bauraum und auch bei optimierten Kühlkörper nur eine begrenzt Menge an Verlustleistung an die Umgebung abgegeben werden kann und dadurch die gesamte Lichtmenge die von einer Retrofit LED-Lampe erzeugt werden kann begrenzt ist.

CN 201 126 821 Y, US 2006/152140 A1 und US 6 234 648 B1 offenbaren jeweils eine LED-Lampe, aufweisend ein LED-Modul mit wenigstens einer farbstoffkonvertierten blauen LED, sowie mindestens einer roten LED, welche auf einem gemeinsamen Träger des LED-Moduls angeordnet sind.

Es ist Aufgabe der vorliegenden Erfindung, eine verbesserte Retrofit LED-Lampe vorzustellen.

Diese Aufgabe wird erfindungsgemäß gelöst durch die Merkmale der unabhängigen Ansprüche 1 und 11, wobei die abhängigen Ansprüche den zentralen Gedanken der Erfindung in besonders vorteilhafter Weise weiterbilden.

Ein erster Aspekt der Erfindung betrifft eine LED-Lampe mit Weisslichtemission ähnlich einer Haushaltskerze, aufweisend ein LED-Modul bestehend aus wenigstens einer farbstoffkonvertierten blauen oder UV-LED, sowie mindestens einer roten monochromatischen LED, wobei das Mischspektrum weisses Licht mit einer zugeordneten Farbtemperatur zwischen 1500K und 2400K, vorzugsweise 1700K und 2100 K bei Raumtemperatur und zwischen 1800K und 2400K, vorzugsweise 2100K und 2300K bei stationärer Betriebstemperatur von zwischen 70°C und 80°C der LED-Lampe ist.

Dieses weiße Licht ist "wärmer" als ein typisches Glühlampenlicht und mit der Farbtemperatur von Kerzen oder stark gedimmten Glühlampenlicht vergleichbar.

Die LED-Lampe kann einen E27-Lampengewindesockel aufweisen.

Die LED-Lampe kann insbesondere einen Reflektor aufweisen, der das LED-Modul ringförmig umgibt.

Die monochromatische LED kann eine dominante Wellenlänge zwischen 600nm und 635nm aufweisen.

Die LED-Lampe kann einen Farbwiedergabeindex CRI von mehr als 75, vorzugsweise mehr als 80, noch mehr bevorzugt mehr als 85 aufweisen.

Eine transparente Schicht kann sowohl die blaue LED wie auch die rote LED tropfenartig überdecken, wobei die transparente Schicht über der roten LED keinen Farbkonversionsstoff aufweist, auch wenn dies nicht ausgeschlossen ist.

Die LED-Lampe kann insbesondere als Halogen- oder Glühbirnen-Retrofitlampe ausgestaltet sein und eine Treiberschaltung in einem Gehäuse sowie einen Sockel zur mechanischen Befestigung in der Art einer Halogenlampe bzw. einer Glühbirne sowie zur elektrischen Versorgung mit DC- oder AC-Spannung aufweisen.

Die LED-Lampe kann eine oder mehrere farbstoffkonvertierte und eine oder mehrere monochromatische LEDs auf einer Leiterplatte (oder mehreren Leiterplatten) aufweisen, wobei die Auswahl durch Abstimmung der zu erreichenden korrelierten Farbtemperatur mit Leistungsdaten der einzusetzenden LEDs und Farbkonversionsmaterial durchzuführen ist.

Die LED-Lampe kann eine Effizienz bei Raumtemperatur von mehr als 80 lm/W, vorzugsweise mehr als 85 lm/W bei einem LED-Strom von mehr als 300mA, bspw. 350mA.

Die farbkonvertierte LED kann einen Lichtstrom von mehr als 120 lm @350mA Betriebstrom erzeugen. Die monochromatische, rote LED kann einen Lichtstrom von mehr als 50 lm @350mA Betriebsstrom erzeugen. Der Gesamtlichtstrom der LED-Lampe kann somit bei Raumtemperatur (25°C) bei einem Betriebsstrom von 350mA für beide LED-Typen mehr als 340 lm betragen, wenn von jedem LED-Typ zwei LEDs auf dem gemeinsamen Träger vorliegen.

Die Erfindung bezieht sich auch auf eine LED-Lampe, aufweisend ein LED-Modul bestehend aus wenigstens einer farbstoffkonvertierten blauen oder UV-LED, sowie mindestens einer roten LED,
wobei das Mischspektrum weisses Licht mit einer Farbtemperatur CCT unterhalb von 2500K erzeugt, und wobei der Farbkonversionsstoff neben einem primären, gelb emittierenden Farbkonversionsstoff einen weiteren Farbkonversionsstoff mit rotem oder grünen Emissionsspektrum aufweist, mit deren Hilfe die resultierende zugeordnete Farbtemperatur in Grenzen an die Zielfarbtemperatur angepasst werden kann, sowie bei Verwendung einer UV-LED einen dritten Farbkonversionsstoff welcher im blauen Bereich emittiert.

Ein bevorzugtes Ausführungsbeispiel der Erfindung wird jetzt Bezug nehmend auf die einzige Figuren beschrieben.
- Figur 1: zeigt ein LED-Modul für eine Retrofit LED-Lampe zeigt, und
- Figur 2: zeigt das Spektrum verschiedener erfindungsgemässer LED-Module im Vergleich zum Spektrum von Kerzenlicht.

Es ist verhältnismäßig schwierig, bei einer Retrofit-LED-Lampe ein weißes Licht mit sehr niedriger Farbtemperatur (CCT) von beispielsweise 1800K bis 2400K zu erzielen, insbesondere, wenn der Farbwiedergabeindex CRI und auch die Effizienz (gemessen beispielsweise in Lumen/Watt) hochgehalten werden sollen. Eine Möglichkeit wäre es sicherlich, einen grünen, einen gelben und einen roten Farbkonversionsstoff mit einer blauen LED zu kombinieren. Nachteil einer solchen Lösung wäre es indessen, dass aufgrund der spektralen Limitierungen verwendbarer roter Phosphore die Gesamteffizienz sehr niedrig wäre und bedingt durch den beschränkten Bauraum und die beschränkte Kühlfähigkeit keine attraktiven brauchbaren Lösungen generiert werden kann.

Daher sieht die Erfindung grundsätzlich vor, eine farbstoffkonvertierte blaue oder UV-LED mit sehr hoher Konversionseffizienz zu benutzen, und zwar vorzugsweise mit einem Farbkonversionsstoff ('Phosphor'), wie er bei Standardweißlicht-LED-Lampen mit einer Farbtemperatur von beispielsweise 6500K verwendet wird, jedoch das die Umwandlung des blauen Lichtes in farbkonvertiertes Licht fast vollständig erfolgt.

Die erfindungsgemäß verwendete Farbstoffkonvertierte LED kann eine Effizienz im Bereich von 90-120% einer LED mit einer Farbtemperatur von 6500K aufweisen.

Wie gesagt, diese farbstoffkonvertierte blaue LED wird erfindungsgemäß kombiniert mit einer monochromatischen, insbesondere roten LED, so dass sich ein Mischspektrum des LED-Moduls mit einem Farbort in der Nähe oder auf der Planck'schen Kurve ergibt, und zwar wie gesagt mit einer Effizienz, die nahe einer standardmäßig verwendeten Weißlicht-LED-Lampe mit einer Farbtemperatur von beispielsweise 6500K liegt.

Die rote LED kann beispielsweise eine dominante Wellenlänge (Peak) in dem Bereich von 600nm bis 635nm aufweisen.

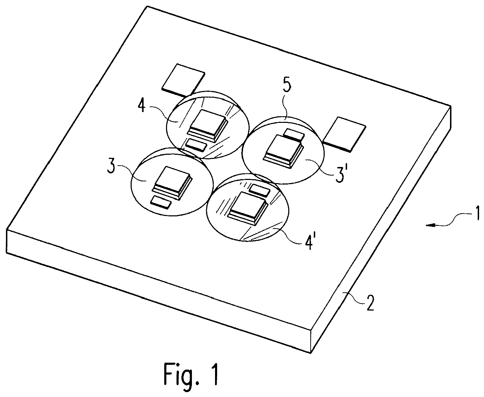

Wie aus der einzigen Figur der Zeichnungen ersichtlich, kann in einer erfindungsgemäßen Retrofit-LED-Lampe ein LED-Modul 1 verwendet werden, das als Träger eine Leiterplatte (PCB) 2 verwendet. In der Darstellung gemäß Figur 1 sind insgesamt vier LEDs vorgesehen, nämlich zwei blaue farbstoffkonvertierte LEDs 3, 3' sowie zwei monochromatische, bevorzugt rote LEDs 4, 4'.

Über sämtlichen LEDs 3, 3', 4, 4' ist vorzugsweise eine tropfenförmige durchlässige Schicht 5 angeordnet.

Die LED-Lampe weist zudem vorzugsweise einen Lampensockel zur mechanischen und elektrischen Kontaktierung der LED-Lampe mit einer Lampenfassung auf, wobei es sich bei dem Lampensockel um einen E14, E17 oder E27 Schraubsockel oder einen G4, G5 oder G6 Stiftsockel oder einen BA9 oder BA15 Bajonettsockel handeln kann.

Als Farbkonversionsstoff kann ein dotierter YAG:Ce verwendet werden. Erfindungsgemäß wird zumindest in geringerer Menge ein zweiter Typ an Farbkonversionsstoff zugesetzt, wie bspw. ein oranger/roter Farbkonversionsstoff mit einem Emissionspeak zwischen 590nm - 650nm oder ein grüner Farbkonversionsstoff mit einem Emissionspeak zwischen 500nm und 540nm.

Die Oberfläche des Trägers 2 kann mit einer hochreflektierende Schicht ("white coating") überzogen werden. Diese hochreflektierende Schicht erstreckt sich angrenzend an den LED-Chip zumindest in dem Bereich, der mit der verkapselnden Schicht 5 überzogen ist. Diese hochreflektierende Schicht kann Pigmente bspw. aus e.g. TiO2, BaSO3, ZrO2, BaTiO3 enthalten.

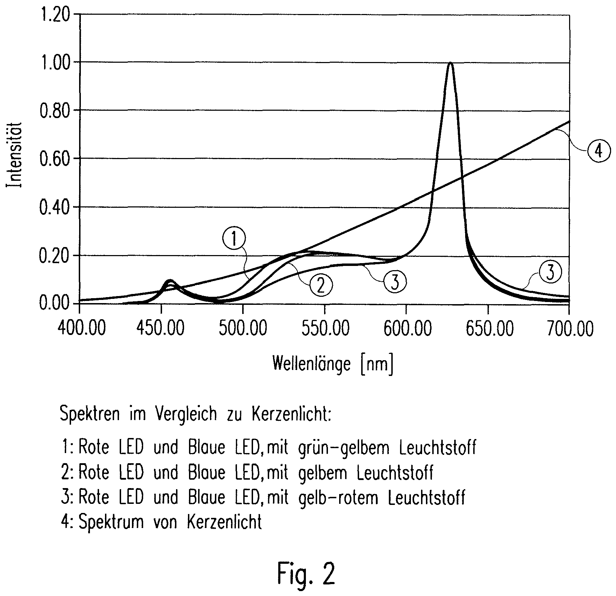

Figur 2 zeigt das Spektrum verschiedener erfindungsgemässer LED-Module im Vergleich zum Spektrum von Kerzenlicht. Dabei sind folgende Ausführungsbeispiele für die LEDs des LED-Moduls im Vergleich zum Kerzenspektrum dargestellt:
Beispiel 1: Rote LED und Blaue LED, mit grün-gelbem Leuchtstoff
Beispiel 2: Rote LED und Blaue LED, mit gelbem Leuchtstoff; bei dem Beispiel 2 handelt es sich nicht um einen Teil der Erfindung, sondern um einen Stand der Technik, der das Verständnis der Erfindung erleichtert.
Beispiel 3: Rote LED und Blaue LED, mit gelb-rotem Leuchtstoff

## Patentansprüche

1. LED-Lampe,
aufweisend ein LED-Modul (1) mit wenigstens einer farbstoffkonvertierten blauen oder UV-LED (3,3'), sowie mindestens einer monochromatischen, roten LED (4,4'), welche auf einem gemeinsamen Träger (2) des LED Moduls (1) angeordnet sind,
wobei das Mischspektrum der wenigstens zwei genannten LEDs weisses Licht mit einer Farbtemperatur zwischen 1500K und 2400K, vorzugsweise 1700K und 2100 K bei Raumtemperatur und einer Farbtemperatur zwischen 1800K und 2400K, vorzugsweise 2100K und 2300K bei stationärer Betriebstemperatur von zwischen 70°C und 80°C der LED-Lampe ist, und wobei die Oberfläche des gemeinsamen Trägers (2) der LEDs (3,3',4,4') mit einer hochreflektiven Schicht überzogen ist, wobei dem Farbkonversionsstoff der blauen oder UV-LED (3,3') zumindest in geringerer Menge ein zweiter Typ Farbkonversionsstoff zugesetzt ist, dessen Peak-Wellenlänge wenigstens 10nm oder 15nm von der dominanten Wellenlänge der roten LED (4,4') beabstandet ist.

2. LED Lampe nach Anspruch 1,
aufweisend einen Reflektor.

3. LED-Lampe nach Anspruch 1 oder 2,
bei der die monochromatische LED (4,4') eine dominante Wellenlänge zwischen 600nm und 635nm aufweist.

4. LED-Lampe nach einem vorhergehenden Ansprüche,
mit einem Farbwiedergabeindex CRI von mehr als 75, vorzugsweise mehr als 80.

5. LED-Lampe nach einem der vorhergehenden Ansprüche,
wobei eine transparente Schicht (5) sowohl die blaue LED (3,3') wie auch die rote LED (4,4') tropfenartig überdeckt.

6. LED-Lampe nach einem der vorhergehenden Ansprüche, die als Halogen- oder Glühbirnen-Retrofitlampe ausgestaltet ist und eine Treiberschaltung in einem Gehäuse sowie einen Sockel zur mechanischen Befestigung in der Art einer Halogenlampe bzw. einer Glühbirne sowie zur elektrischen Versorgung mit DC.- oder AC-Spannung aufweist.

7. LED-Lampe nach einem der vorhergehenden Ansprüche, die zwei farbstoffkonvertierte (3,3') und zwei monochromatische LEDs (4,4') auf einer Leiterplatte PCB (2) aufweist.

8. LED-Lampe nach einem der vorhergehenden Ansprüche, aufweisend eine Effizienz bei Raumtemperatur von mehr als 80 lm/W bei einem LED-Strom von mehr als 300mA.

9. LED-Lampe nach einem der vorhergehenden Ansprüche, wobei als Farbkonversionsstoff kein YAG verwendet ist.

10. LED-Lampe nach Anspruch 9,
wobei der zweite Typ Farbkonversionsstoff ein roter Farbkonversionsstoff auf Nitridbasis ist, bspw. mit einem Emissionspeak bei 650nm.

11. LED-Lampe,
aufweisend eine LED-Modul (1) bestehend aus wenigstens einer farbstoffkonvertierten blauen oder UV-LED (3,3'), sowie mindestens einer monochromatischen, roten LED (4,4'),
wobei das Mischspektrum weisses Licht mit einer Farbtemperatur unterhalb von 2500K erzeugt, und wobei der Farbkonversionsstoff neben einem primären Farbkonversionsstoff einen weiteren Farbkonversionsstoff mit rotem Emissionsspektrum aufweist, dessen Peak-Wellenlänge wenigstens 5nm, vorzugsweise 10nm oder 15nm von der dominanten Wellenlänge der roten LED beabstandet ist.

## Claims

1. LED lamp
comprising an LED module (1) with at least one dye-converted blue or UV LED (3, 3'), as well as at least one monochromatic, red LED (4, 4'), which are arranged on a common carrier (2) of the LED module (1),
wherein the mixing spectrum of the at least two specified LEDs is white light with a color temperature between 1500K and 2400K, preferably 1700K and 2100K, at room temperature and a color temperature between 1800K and 2400K, preferably 2100K and 2300K, at constant operating temperature between 70°C and 80°C of the LED lamp, and wherein the surface of the common carrier (2) of the LEDs (3, 3', 4, 4') is coated with a highly reflective layer, wherein at least a small amount of a second type of color conversion substance whose peak wavelength has at least a distance of 10 nm or 15 nm from the dominant wavelength of the red LED (4, 4') is added to the color conversion substance of the blue or UV LED (3, 3').

2. LED lamp according to Claim 1,
comprising a reflector.

3. LED lamp according to Claim 1 or 2,
in which the monochromatic LED (4, 4') has a dominant wavelength between 600 nm and 635 nm.

4. LED lamp according to a preceding claim, with a color rendering index CRI of more than 75, preferably more than 80.

5. LED lamp according to one of the preceding claims, wherein a transparent layer (5) covers both the blue LED (3, 3') and the red LED (4, 4') in a drop-like manner.

6. LED lamp according to one of the preceding claims, which is designed as a halogen or light bulb retrofit lamp and comprises a driver circuit in a housing as well as a base for mechanical fastening in the manner of a halogen lamp or a light bulb as well as for the electrical supply with DC or AC voltage.

7. LED lamp according to one of the preceding claims, which comprises two dye-converted (3, 3') and two monochromatic LEDs (4, 4') on a printed circuit board PCB (2).

8. LED lamp according to one of the preceding claims, having an efficiency at room temperature of more than 80 lm/W at an LED current of more than 300 mA.

9. LED lamp according to one of the preceding claims, wherein no YAG is used as color conversion substance.

10. LED lamp according to Claim 9,
wherein the second type of color conversion substance is a red color conversion substance on the basis of nitride, e.g. with an emission peak at 650 nm.

11. LED lamp
comprising an LED module (1) consisting of at least one dye-converted blue or UV LED (3, 3'), as well as at least one monochromatic, red LED (4, 4'),
wherein the mixing spectrum generates white light with a color temperature below 2500 K, and wherein the color conversion substance comprises, in addition to the primary color conversion substance, a further color conversion substance with a red emission spectrum, whose peak wavelength has at least a distance of 5 nm, preferably 10 nm or 15 nm, from the dominant wavelength of the red LED.

## Revendications

1. Lampe à LED,
présentant un module à LED (1) possédant au moins une LED UV ou bleue à conversion de couleur (3, 3') ainsi qu'au moins une LED monochromatique rouge (4, 4') qui sont disposées sur un support commun (2) du module à LED (1) ;
le spectre mixte des au moins deux LED citées étant de la lumière blanche d'une température de couleur comprise entre 1500 K et 2400 K, de préférence entre 1700 K et 2100 K, à température ambiante, et d'une température de couleur comprise entre 1800 K et 2400 K, de préférence entre 2100 K et 2300 K à une température de fonctionnement stationnaire de la lampe à LED comprise entre 70 °C et 80 °C, la surface du support commun (2) des LED (3, 3', 4, 4') étant recouverte d'une couche hautement réfléchissante, la substance de conversion de couleur de la LED UV ou bleue (3, 3') étant complétée d'une moindre quantité d'un deuxième type de substance de conversion de couleur dont la longueur d'onde maximale est écartée d'au moins 10 nm ou 15 nm de la longueur d'onde dominante de la LED rouge (4, 4').

2. Lampe à LED selon la revendication 1,
présentant un réflecteur.

3. Lampe à LED selon la revendication 1 ou 2,
dans laquelle la LED monochromatique (4, 4') présente une longueur d'onde dominante comprise entre 600 nm et 635 nm.

4. Lampe à LED selon l'une des revendications précédentes, présentant un indice de rendu des couleurs IRC de plus de 75, de préférence de plus de 80.

5. Lampe à LED selon l'une des revendications précédentes, dans laquelle une couche transparente (5) recouvre la LED bleue (3, 3') ainsi que la LED rouge (4, 4') à la manière de gouttes.

6. Lampe à LED selon l'une des revendications précédentes, conçue pour servir de rattrapage de lampe halogène ou à incandescence et présentant un driver dans un boîtier ainsi qu'un culot permettant leur fixation mécanique à la manière d'une lampe halogène ou à incandescence et permettant leur alimentation électrique par une tension continue ou alternative.

7. Lampe à LED selon l'une des revendications précédentes, présentant deux LED à conversion de couleur (3, 3') et deux LED monochromatiques (4, 4') sur une carte de circuit imprimé PCB (2).

8. Lampe à LED selon l'une des revendications précédentes, présentant une efficacité à température ambiante de plus de 80 lm/W pour une intensité de LED de plus de 300 mA.

9. Lampe à LED selon l'une des revendications précédentes, dans laquelle la substance de conversion de couleur est différente du YAG.

10. Lampe à LED selon la revendication 9,
dans laquelle le deuxième type de substance de conversion de couleur est une substance de conversion de couleur rouge à base de nitrure, présentant par exemple un pic d'émission à 650 nm.

11. Lampe à LED,
présentant un module à LED (1) composé d'au moins une LED UV ou bleue à conversion de couleur (3, 3') ainsi que d'au moins une LED monochromatique rouge (4, 4') ;
le spectre mixte produisant de la lumière blanche d'une température de couleur inférieure à 2500 K, la substance de conversion de couleur présentant, outre une substance de conversion de couleur primaire, une autre substance de conversion de couleur à spectre d'émission rouge dont la longueur d'onde maximale est écartée d'au moins 5 nm, de préférence de 10 nm ou 15 nm de la longueur d'onde dominante de la LED rouge.
